# EUROPEAN PATENT SPECIFICATION

(11) **EP 0 402 086 B1**
(45) Date of publication and mention of the grant of the patent: **15.11.1995**
(21) Application number: 90306077.0
(22) Date of filing: 04.06.1990
(51) Int. Cl.: H01R 13/11, H01R 13/193

(54) **Contact in a socket for an electric part**
Kontakt in einem Sockel für ein elektrisches Bauteil
Contact dans une prise pour un composant électrique

(30) Priority: 08.06.1989 JP 147430/89
(43) Date of publication of application: 12.12.1990
(73) Proprietor: YAMAICHI ELECTRONICS CO., LTD., Ohta-ku, Tokyo (JP)
(72) Inventor: Matsuoka, Noriyuki, Tokyo (JP); Uratsuji, Kazumi, Tokyo (JP)
(74) Representative: Ben-Nathan, Laurence Albert

(56) References cited:
- EP-A- 0 082 679
- US-A- 3 763 459
- SIEMENS COMPONENTS, vol. 22, No. 2, April 1987, MUNCHEN, DE, pp. 70 - 73; Hoolhorst et al.: "New Modular Equipment Connector..."

## Description

### BACKGROUND OF THE INVENTION

### 1. Field of the Invention

This invention relates to a contact which is effectively used in a socket for an electric part such as an IC socket or the like, and particularly to a contact, in which contact elements of the contact are forcedly dilated by a lateral movement in one direction of a moving plate provided on a socket body so that terminals of the electric part can be inserted and removed with no load, and the dilating force is canceled by a lateral movement in the other direction of the moving plate so that the terminals of the electric part can be brought into contact with contact elements of the contact.

### PRIOR ART

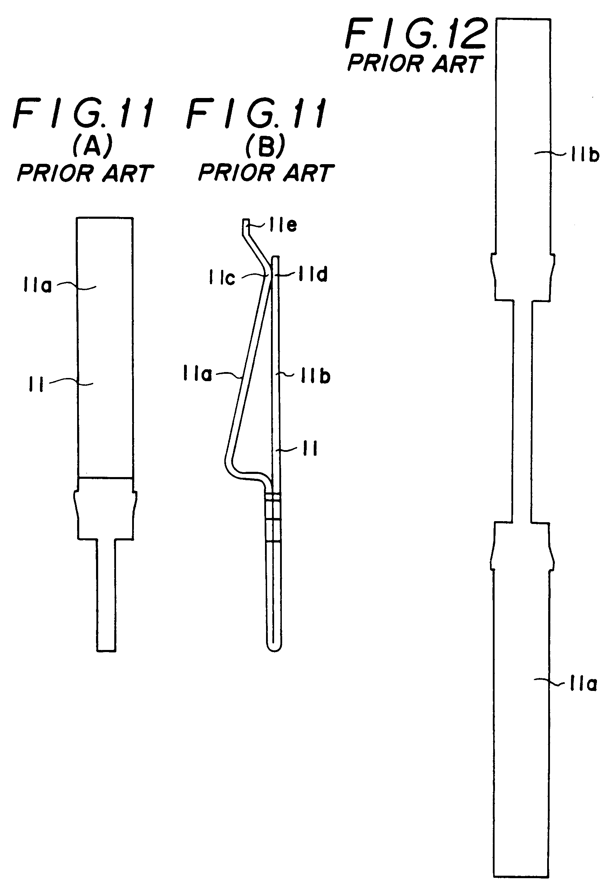

A conventional contact of this type, as shown a representative example in Figs. 11 and 12, has a pair of elongated contact elements 11a and 11b disposed in such a manner as that plate surfaces (outer surfaces of a raw material) thereof are faced with each other, contacting portions 11c and 11d being formed in the vicinity of the free ends of the contacting elements 11a and 11b so that a terminal of an electric part can be pinched between the plate surfaces of the contacting portions 11c and 11d, the leading end of the contact element 11a extending upward beyond the leading end of the other contact element 11b to form a pressure receiving portion 11e.

This conventional contact 11 is formed in such a manner as that the contact elements 11a and 11b, as shown in Fig. 12, are developed and perforated in that state, and then folded back into two along a connecting portion to form the afore-mentioned facing state.

When in operation, the contact 11 is held by a socket body and the pressure receiving portion is engaged with a lower surface of a moving plate which horizontally moves along the upper surface of the socket body, so that a pushing force is applied to the pressure receiving portion 11e of the contact 11 by a lateral movement in one direction of the moving plate to dilate the contacting portions 11c and 11d and an electric part is inserted therein and removed therefrom with no load, and on the other hand, the dilating force is canceled by a lateral movement in the other direction of the moving plate, thereby to realize the above-mentioned pinching contact.

However, this conventional contact requires a comparatively complicated bending treatment and a large amount of a metallic material is consumed for a single contact. In addition, the productivity of the contact is inferior, dimensional accuracy thereof is difficult to obtain, and the contact becomes expensive.

The present invention has been accomplished in view of the above problems.

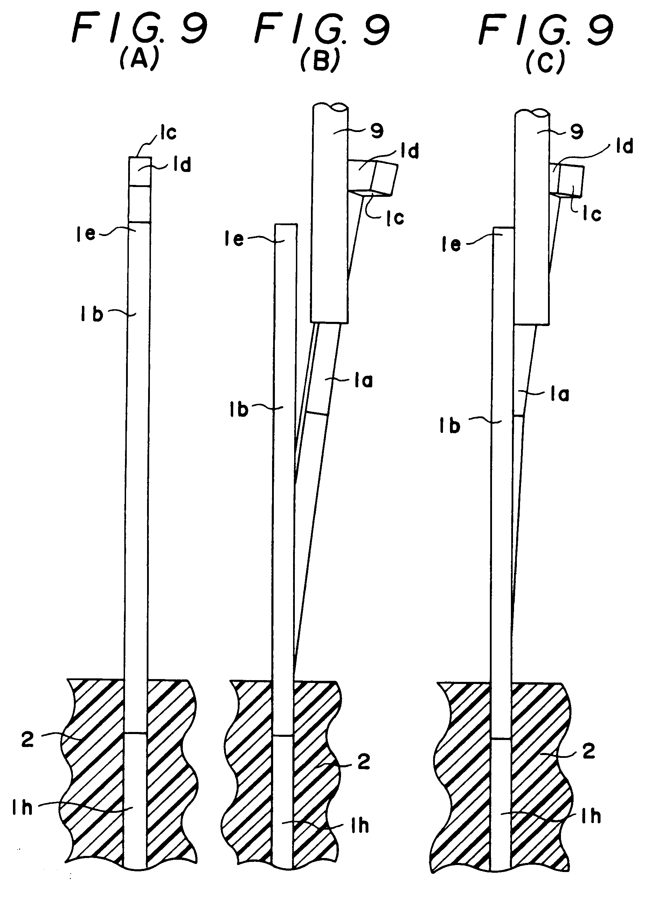

SIEMENS COMPONENTS, Vol. 22, No. 2, April 1987, pages 70 - 73, Hooshorst et al: "New modular equipment connectors for ribbon cables in accordance with DIN 41651", illustrates in Fig. 9 a bilateral contact spring having a pair of offset spring legs which define a male contact receiving gap therebetween and are elastically displaceable to facilitate insertion of a male contact into the gap from above. This contact spring also requires a bending and a tapering of the end portions of the contact pieces.

The pre-characterising part of Claim 1 is based on this prior art.

### SUMMARY OF THE INVENTION

It is therefore an object of the present invention to provide an improved contact in a socket for an electric part which can solve the above-mentioned problems.

The invention provides a contact in accordance with Claim 1.

The invention also provides an assembly of a socket body, a contact and a movable block, in accordance with Claim 2.

The contact is planted in a socket body, and an end portion of the inverted general L-shaped contact element of the contact is engaged with the moving plate which is laterally movably disposed on an upper surface of the socket body. By a lateral movement of the moving plate, the reversed generally L-shaped contact is dilated in the perforating direction against its elasticity and a terminal of an electric part is inserted with no load between the other contact element and the inverted generally L-shaped contact element. By removing the dilating force, the inverted generally L-shaped contact piece is restored to pinch the terminal in the perforating direction.

The above and other objects and features of the present invention will become more apparent to those skilled in the art upon reading the following detailed description of the preferred embodiment with reference to the accompanying drawings.

### BRIEF DESCRIPTION OF THE DRAWINGS

Fig. 1A is a front view of a contact according to one embodiment of the present invention;
Fig. 1B is a side view thereof;
Fig. 1C is a top view thereof;
Fig. 2 is a perspective view thereof;
Fig. 3 is a perspective view of a socket for an electric part in which the contact is used;
Fig. 4 is a sectional view of the socket;
Fig. 5 is a sectional view of the socket, in which the contact is dilated by exerting a lateral force to the moving plate;
Fig. 6 is a sectional view of the socket in which an electric part is attached;
Fig. 7 is a sectional view of the socket in which the lateral force exerted to the moving plate is removed from the state shown in Fig. 6 to attain a contacted state;
Figs. 8 and 9 are enlarged views showing the relation between the movement of the contact and the terminal of an electric part;
Fig. 8A is a plan view of the contact;
Fig. 8B is a plan view in which a lateral force is exerted to the contact to insert the terminal therein;
Fig. 8C is a plan view in which the lateral force exerted to the contact is removed to attain a contacted state;
Fig. 9A is a side view corresponding to Fig. 8A;
Fig. 9B is a side view corresponding to Fig. 8B;
Fig. 9C is a side view corresponding to Fig. 8C;
Fig. 10A is a plan view of the contact of Fig. 1, in which a state before the terminal is pinched and a state after the terminal is pinched are shown by way of engagement with a moving plate;
Fig. 10B is a plan view showing another example thereof;
Fig. 10C is a plan view showing still another example thereof;
Fig. 11A is a side view of the contact;
Fig. 11B is a front view thereof; and
Fig. 12 is a development thereof.

### DETAILED DESCRIPTION OF THE PREFERRED EMBODIMENT

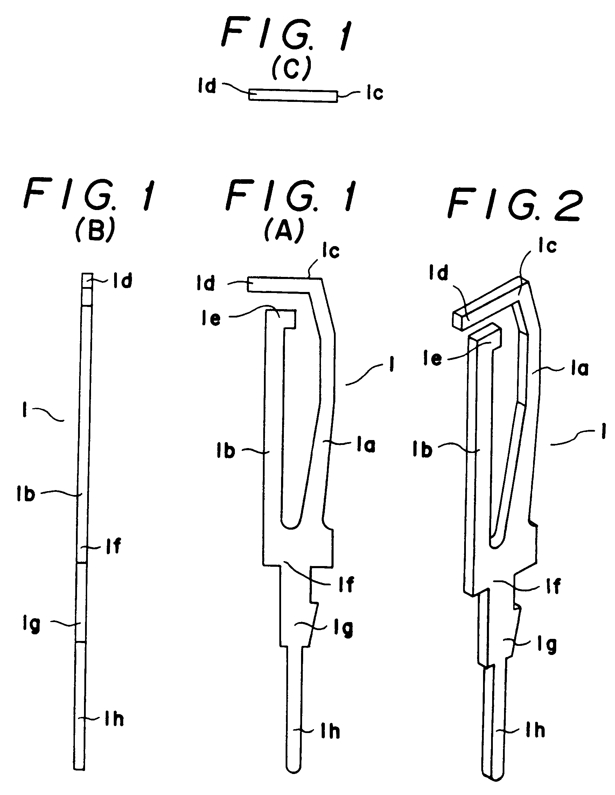

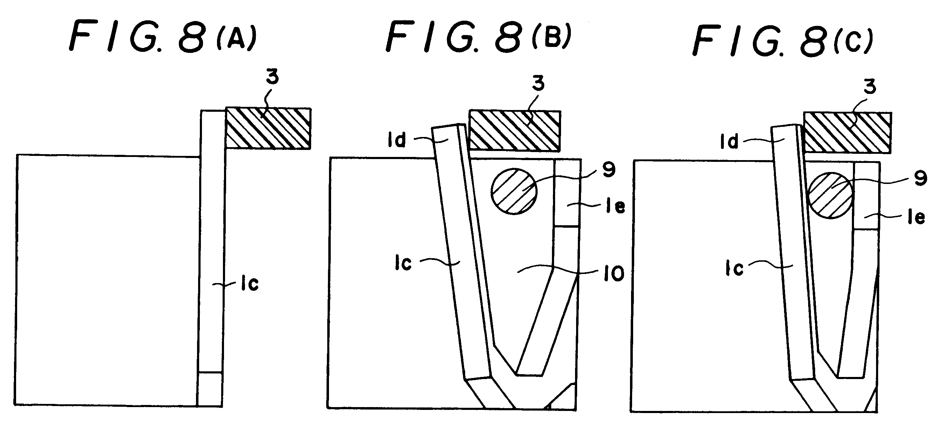

One preferred embodiment of the present invention will be described with reference to Figs. 1 through 10.

The numeral 1 is a contact of the present invention. The contact 1 is formed by perforating a belt-like metallic material. By the perforation, fork-like first and second elongated contact elements 1a and 1b which are faced with respect to each other at the sheared surfaces and extends in parallel relation are formed.

The first and second elongated contact elements 1a and 1b are connected with each other at root portions thereof and provided with a contacting portion, respectively, at leading ends thereof. The contacting portion of the first elongated contact element 1a is formed by an inverted generally L-shaped contact element 1c projecting in the facing direction which is formed by being bent by means of perforation. The both contacting portions are arranged such that one contacting portion is located in an upper position and the other contacting portion is located in a lower position, and both the contacting portions are displaced in the perforating direction without interfering with each other. The first elongated contact element 1a, the second elongated contact element 1b, the inverted generally L-shaped contact element 1c and the contacting portion (contact element 1e as will be described later) are arranged in a relation of upper and lower positions in a same plane. That is, the contact elements 1c and 1e are arranged such that the sheared surfaces formed by perforation are vertically faced with each other. Also, the inverted generally L-shaped contact element 1c and the contact element 1e are arranged in such a manner as to be displaced in phase in the perforating direction within the thickness of the sheared surfaces formed by perforation. The first elongated contact element 1a is displaced in phase in the perforating direction by applying a pushing force from an outer surface (outer surface of a raw material provided by perforation) side perpendicular to the perforating direction with respect to the inverted generally L-shaped contact element 1c, and at the same time, the inverted generally L-shaped contact element 1c is twist displaced in the perforating direction about the first elongated contact element 1a to form a terminal insertion gap directing in the perforating direction between an outer surface of the second elongated contact piece 1b and the inverted generally L-shaped contact element 1c.

In order to apply the pushing force to the inverted generally L-shaped contact element 1c, a pressure receiving portion 1d is formed by a free end of the inverted generally L-shaped contact element 1c. As one suitable example, the free end of the inverted generally L-shaped contact element 1c projects backward beyond the contacting portion at the leading end of the second elongated contact element 1b to form the pressure receiving portion 1d. Also, the second contact element 1b is provided at the leading end thereof with the contact element 1e projecting in an inverted generally L-shape toward the first elongated contact element 1a.

As described above, the contact elements 1c and 1e are disposed in such a manner as to be in upper and lower positions. The contact element 1c is displaced in the perforating direction to form a no load insertion gap 10 directing in the perforating direction between the contact element 1e and contact element 1c. After a terminal 9 of the electric part 8 is inserted into the gap 10, the contact element 1c is restored to its original position. In this way, the terminal 9 is pinched in a vertically displaced position on the axial line of the terminal 9.

Furthermore, the first and second elongated contact elements 1a and 1b are provided at a connected portion 1f with a press-fit portion 1g for fixing to the socket body. Beneath the press-fit portion 1g, an external terminal 1h is formed in such a manner as to penetrate the socket body 2 and project downward below the socket body 2 in order to be connected with a printed board, etc. The external terminal 1h extends in a same plane as the first and second elongated contact elements 1a and 1b.

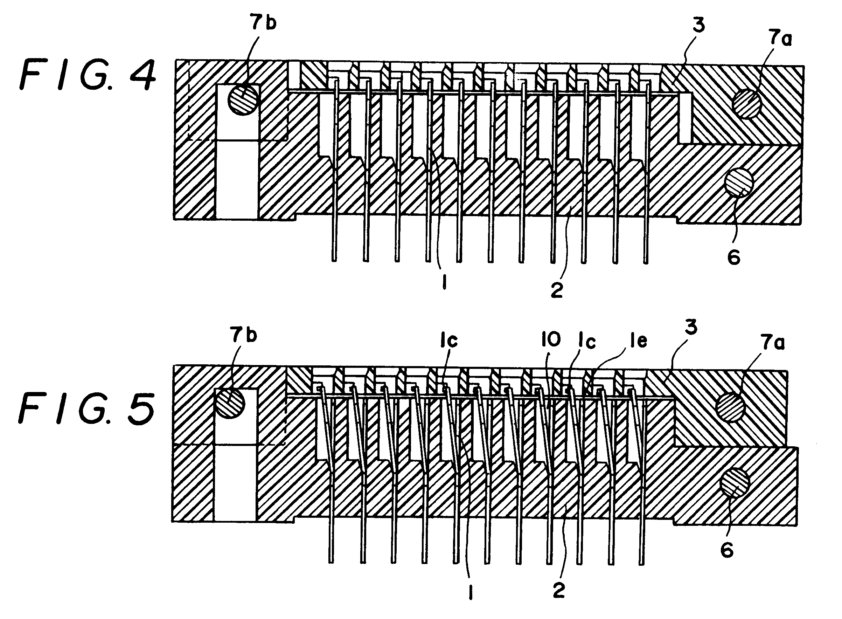

The contact 1 such constructed is planted and fixed to the socket body 2 similar to one to which the conventional contact 11 is planted using the press-fit portion 1g. Also, a moving plate 3 for horizontally moving along the upper surface of the socket body 2 is provided. The terminal 9 of the electric part 8 placed on the upper surface of the moving plate 3 is inserted into the terminal insertion hole 3a formed in the moving plate 3 in order to be contacted with the contact 1. Furthermore, the pressure receiving portion 1d formed on the leading end of the inverted generally L-shaped contact element 1c of the first elongated contact element 1a is engaged with the lower surface of the moving plate 3 (see Fig. 4).

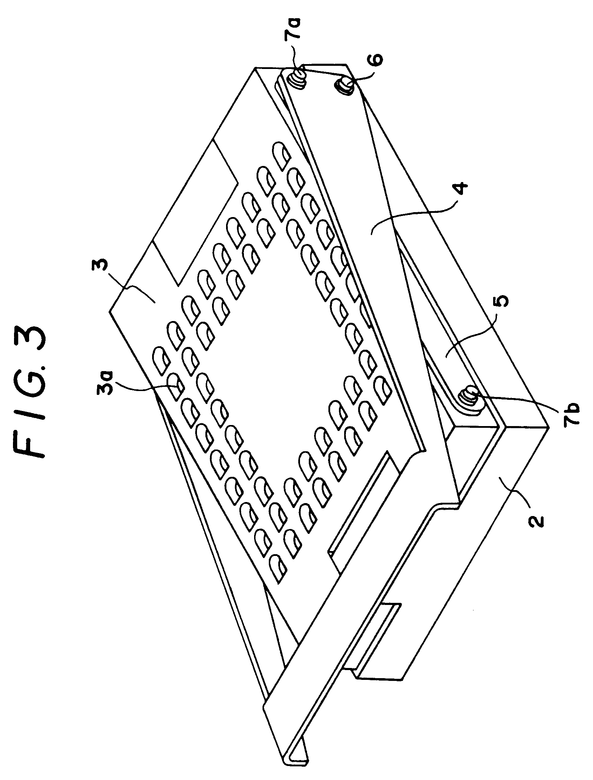

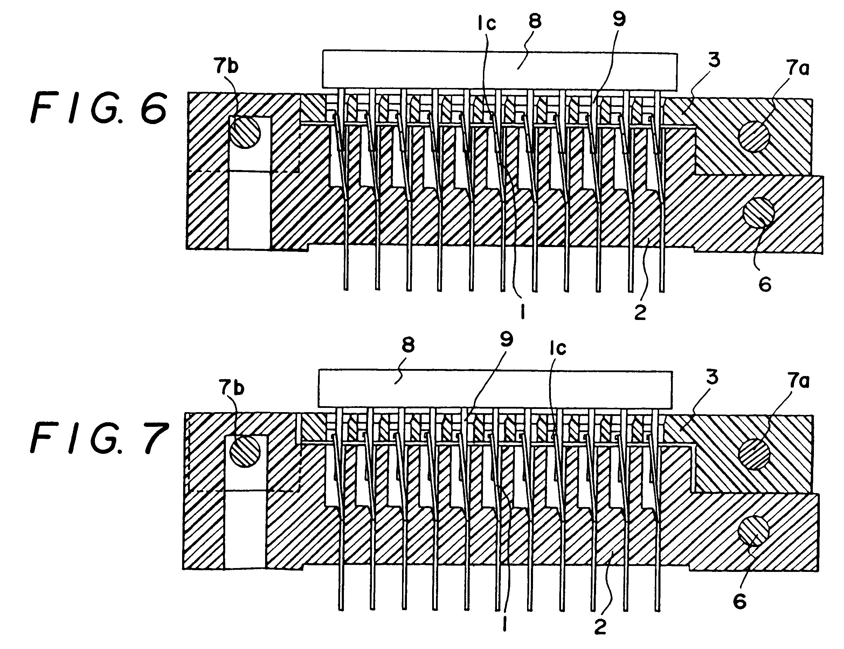

As for a lateral movement operation means for the moving plate 3, as shown in Fig. 3 for example, a root end of an operating lever 4 is pivotally attached to one end of the moving plate 3 through a supporting shaft 6. The moving plate 3 also has a transmission lever 5 one end of which is pivotally attached to the other end of the moving plate 3. The other end of the transmission lever 5 and the root end of the operating lever 4 is pivotally attached to the moving plate 3 through the transmission shaft 7a. In this way, the lateral movement means for the moving plate 3 is formed. When the operating lever 4 is pivoted about the supporting shaft 6 and the moving plate 3 is laterally moved leftward in the drawings as shown in Fig. 5 through the transmission shafts 7a and 7b, a pushing force directing in the left direction is exerted to the pressure receiving portion 1d which is engaged with the moving plate 3. As a result, the first elongated contact element 1a which is in a normally closed state is displaced in such a manner as to be forcedly dilated in the perforating direction as shown in Figs. 5, 8B and 9B to form the terminal insertion gap 10 between the contact element 1e of the second elongated contact element 1b and the first elongated contact element 1a. In this way, as is shown in Figs 6, 8B and 9B, the terminal 9 of the electric part 8 is inserted into the terminal insertion hole 3a formed in the moving plate 3 in order to be inserted into the terminal insertion gap 10 with no load. That is, the terminal 9 is inserted between the outer surface of the inverted generally L-shaped contact element 1c and the contact element 1e of the second elongated contact element 1b.

In the foregoing state, when the pivoting force exerted to the operating lever 4 is removed, the dilating force exerted to the pressure receiving portion 1d is removed through the moving plate 3 and the first elongated contact element 1a is restored to its normally closed state by its elasticity while laterally moving the moving plate 3 in the opposite direction. As a result, the terminal 9 of the electric part 8 is pinched between the inverted generally L-shaped contact element 1c as a contacting portion of the first contact element 1a and the contact element 1e of the second elongated contact element 1b to obtain an electric contact (see Figs. 7, 8C and 9C).

Next, in order to remove the terminal 9 of the electric part 8 from the contact 1 with no load, the operating lever 4 is pivoted about the supporting shaft 6 again to exert a lateral moving force to the moving plate 3 through the transmission shafts 7a and 7b. As a result, a pushing force is exerted to the pressure receiving portion 1d of the contact 1 to forcedly dilate the first elongated contact element 1a against its elasticity and a pinching force exerted to the terminal 9 of the electric part 9 is removed to attain a released state.

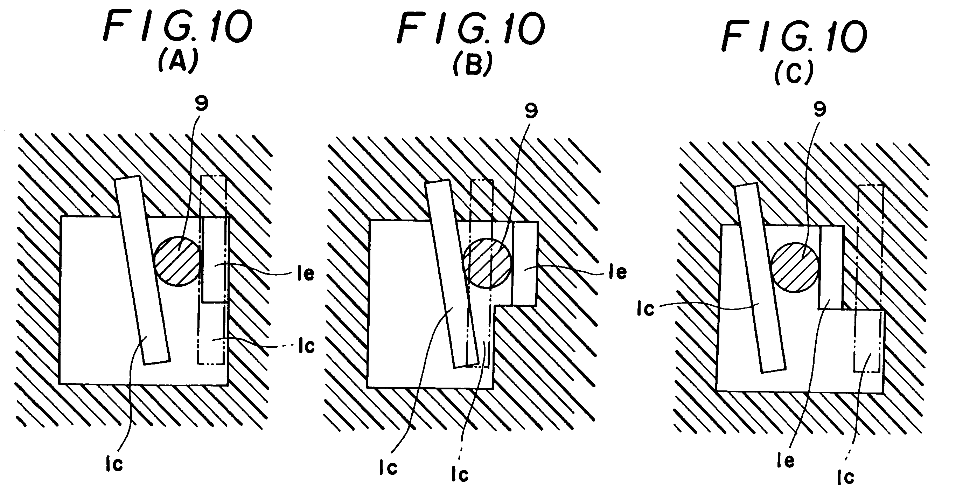

Furthermore, in order to adjust the force for pinching the terminal 9 of the electric part 8 between the first elongated contact element 1a and the second elongated contact element 1b, as is shown in Fig. 10A, both the first elongated contact element 1a and the second elongated contact element 1b or the selected one of the first or second elongated contact element 1a or 1b are subjected to a small amount of bending treatment in the perforating direction, and when looked from above, the inverted generally L shaped contact element 1c as a contacting portion of the first contact element 1a and the contact element 1e of the second elongated contact element are arranged to be faced with each other within the thickness of said contact element so that the terminal is pinched in a displaced position shown by the solid line from a position shown by the imaginary line, or otherwise, the inverted generally L-shaped contact element 1c and the contact element 1e are arranged in such a manner as to be displaced in phase in the perforating direction beyond the thickness of the sheared surfaces formed by perforation as shown by the imaginary line in Figs. 10B and 10C, and the first elongated contact element 1a is displaced in phase in the direction as shown by the solid line in Fig. 10B or the first elongated contact element 1a is displaced in phase in the opposite direction as shown in Fig. 10C to attain the pinching contact. The pinching force by the contact elements 1c and 1e becomes strongest in the embodiment shown in Fig. 10C.

As described in the foregoing, according to the present invention, for example, the inverted generally L-shaped contact element is dilated against its elasticity in the perforating direction by a pushing force, etc. through the moving plate disposed on the socket body in such a manner as to be able to laterally move along the upper surface thereof and a terminal of an electric part can be inserted with no load into a gap formed between the inverted generally L-shaped contact element and the other contact element, and by removing the dilating force, the inverted generally L-shaped element is restored to its original position to realize a favorable pinching contact of the terminal in position vertically displaced from the axial line. This function can be effectively realized in a contact form which is given by the afore-mentioned perforation.

According to the above-mentioned contact, there can be provided a contact for the use of zero insertion force which does not required such a complicated bending work as in the conventional contact, the consumption of metallic material for manufacturing a single contact is reduced as much as possible to improve the yield of production, excellent in productivity, high in dimensional accuracy and inexpensive.

Although the present invention has been described with reference to a preferred embodiment, the invention is not limited to this embodiment. Many modifications and changes can of course be made within the scope of the appended claims.

## Claims

1. A contact (1) for insertion into a socket of an electrical part and for receiving a terminal therein, a first elongated contact element (1a) and a second elongated contact element (1b) made of a resilient conductive material, said contact elements (1a,1b) being interconnected at respective one ends thereof to form a contact terminal for insertion into a socket, and having at the other ends thereof respective first and second contact portions (1c,1e) which are elongated transversely of said contact elements (1a,1b) and each extending towards the other elongate contact element, said first contact portion (1c) on said first contact element (1a) being further from said one ends in the direction of elongation of said contact elements (1a,1b) than said second contact portion (1e) of said second contact element (1b), said contact portions (1c,1e) being positioned for being elastically displaceable in a direction laterally of both the direction of elongation of said contact elements and said contact portions whereby said contact portions (1c,1e) can be resiliently separated in said lateral direction to form a terminal receiving opening (10) therebetween into which a terminal can be inserted under no load, and can thereafter move together to grip the terminal therebetween, characterized in that said first and second contact elements (1a,1b) are disposed in a spaced parallel relationship in a flat plane, and in that said first and second contact portions (1c,1e) are disposed in a spaced opposed relationship in said flat plane with the lower surface of said first contact portion (1c) and the upper surface of said second contact portion (1e) facing each other and with said first contact portion extending past said second contact portion (1e) in the direction of elongation of said first contact portion (1c), the part of said first contact portion extending past said second contact portion being a pressure receiving part (1d), said contact portions (1c,1e) being displaceable relative to one another in a direction laterally of both said direction of elongation of said contact elements and said contact portions and transversely to said flat plane without interfering with each other, predominantly by a twist displacement of first contact portion (1c) about said first contact element (1a) to form said terminal receiving opening (10) between said first and second contact portions (1c,1e), when a force is applied to said pressure receiving part (1d).

2. An assembly comprising a socket body (2) having at least one contact receiving recess therein, a contact (1) according to Claim 1 for receiving a terminal and positioned in said recess, and a movable block (3) on said socket body (2) which is movable in said lateral direction which is normal to the direction of contact between a terminal and the contact (1), when a terminal is inserted in use into the contact, and having a contact engaging portion thereon disposed to engage said pressure receiving part (1d); wherein said block is movable in said lateral direction to apply a force to said pressure receiving part (1d) to displace said first contact portion (1c) relative to said second contact portion (1e) to permit receiving of a terminal between said first and second contact portions (1c,1e).

3. An assembly according to Claim 2 wherein said second contact portion (1e) is normally disposed in said socket body (2) so that it is displaced with respect to said first contact portion (1c) which lies on one side of said second contact portion (1e) and which is displaced to the other side of said second contact portion (1e) on movement of said block (3) in said lateral direction (Fig. 10(C)).

## Patentansprüche

1. In einen Sockel eines elektrischen Bauteils einfügbarer Anschlußkontakt (1) für das Ende eines Leiters, bestehend aus einem ersten gestreckten Kontaktelement (1a) und einem zweiten gestreckten Kontaktelement (1b) aus leitendem, federelastischem Material, wobei
die Kontaktelemente (1a, 1b) einen Ends, einen am Sockel ansetzbaren Steckkontakt ausbildend, zusammengefaßt sind,
die Kontaktelemente (1a, 1b) anderen Ends in gestreckte, quer zu den Kontaktelementen (1a, 1b) und gegenläufig zueinander verlaufende, kontaktgebende Endbereiche (1c, 1e) übergehen,
wobei der kontaktgebende Endbereich (1c) des ersten Kontaktelementes (1a) einen größeren Abstand vom Grund der Kontaktelemente (1a, 1b) aufweist als der kontaktgebende Endbereich (1e) des zweiten Kontaktelementes (1b),
die kontaktgebenden Endbereiche (1c, 1e) gegen eine den Kontaktelementen (1a, 1b) innewohnende Rückstellkraft spreizbar sind,
zwischen die im gespreizten Zustand einen Durchgang (10) ausbildenden kontaktgebenden Endbereiche (1c, 1e) das Ende des anzuschließenden Leiters spannungsfrei einfügbar ist und
die sich unter der Einwirkung der den Kontaktelementen (1a, 1b) innewohnenden Rückstellkraft wieder aufeinanderzubewegenden kontaktgebenden Endbereiche (1c, 1e) das angesetzte Ende des Leiters klemmen,
dadurch gekennzeichnet, daß
das erste und das zweite Kontaktelement (1a, 1b) in einer gemeinsamen Ebene im Abstand voneinander verlaufen,
der erste und der zweite kontaktgebende Endbereich (1c, 1e) der Kontaktelemente (1a, 1b) in der gemeinsamen Ebene der Kontaktelemente im Abstand voneinander verlaufen,
die Unterseite des kontaktgebenden Endbereichs (1c) des ersten Kontaktelementes (1a) der Oberseite des kontaktgebenden Endbereichs (1e) des zweiten Kontaktelementes (1b) zugewandt ist,
der kontaktgebende Endbereich (1c) des ersten Kontaktelementes (1a) über den kontaktgebenden Endbereich (1e) des zweiten Kontaktelementes (1b) vorspringt,
der Überstand (1d) des kontaktgebenden Endbereichs (1c) des ersten Kontaktelementes (1a) über den kontaktgebenden Endbereich (1e) des zweiten Kontaktelementes (1b) eine Druckangriffsfläche ausbildet,
die kontaktgebenden Endbereiche (1c, 1e) der Kontaktelemente (1a, 1b) quer zu den Kontaktelementen (1a, 1b) gegenläufig zueinander unter Ausschluß eines elektrischen Kontaktes miteinander verlagerbar sind,
vorzugsweise durch eine dem ersten Kontaktelement (1a) über den kontaktgebenden Endbereich (1c) vermittelte Drallbewegung,
so einen Durchgang (10) zwischen den kontaktgebenden Endbereichen (1c, 1e) der Kontaktelemente (1a,1b) für das Ende eines anzusetzenden Leiters ausbildend,
wenn Druck auf den Überstand (1d) des kontaktgebenden Endbereichs (1c) des ersten Kontaktelementes (1a) ausgeübt wird.

2. Anschlußsystem bestehend aus einem Sockel mit mindestens einer Aufnahme für einen Kontakt nach Anspruch 1 für den Anschluß eines Leiters und einem auf dem Sockel (2) aufsitzenden, gegenüber dem Sockel (2) senkrecht zum Kontakt (1) und zum anzuschließenden bzw. angeschlossenen Leiter verlagerbaren Stellglied (3) mit einem in Wechselwirkung mit dem Überstand (1d) des kontaktgebenden Endbereichs (1c) des ersten Kontaktelementes (1a) des Kontaktes (1) tretenden Druckstück, über das bei Betätigung des Stellgliedes (3) der kontaktgebende Endbereich (1c) des ersten Kontaktelementes (1a) eine Verlagerung gegenüber dem kontaktgebenden Endbereich (1e) des zweiten Kontaktelementes (1b) im Sinne der Ausbildung des Durchgangs (10) zwischen den kontaktgebenden Endbereichen (1a, 1b) erfährt.

3. Anschlußsystem nach Anspruch 2, dadurch gekennzeichnet, daß die Ausgangslage der kontaktgebenden Endbereiche (1e, 1c) der Kontaktelemente (1a, 1b) im die Kontakte (1) aufnehmenden Block in der Weise vorgegeben ist, daß der unter der Einwirkung des Stellgliedes (3) zur Ausbildung des Durchganges (10) zwischen den kontaktgebenden Endbereichen (1c, 1e) verlagerbare kontaktgebende Bereich (1c) von der kontaktgebenden Anlagefläche des kontaktgebenden Endbereichs (1e) des Kontaktelementes (1b) abgekehrten Seite über den kontaktgebenden Endbereich (1e) des Kontaktelementes (1b) in die den Durchgang (10) zwischen dem kontaktgebenden Bereich (1c) und dem kontaktgebenden Bereich (1e) ausbildende Lage hinaus zu verlagern ist.

## Revendications

1. Contact (1) pour insertion dans une prise d'un composant électrique et pour y recevoir une borne, un premier élément de contact allongé (1a) et un deuxième élément de contact allongé (1b) faits en matériau conducteur élastique, lesdits éléments de contact (1a, 1b) étant reliés entre eux à des premierès de leurs extrémités respectives pour former une terminaison de contact pour insertion dans une prise, et comportant à leurs autres extrémités une première et une deuxième parties de contact (1c, 1e) respectives qui sont allongées transversalement par rapport auxdits éléments de contact (1a, 1b) et chacune s'étendant vers l'autre élément de contact allongé, ladite première partie de contact (1c) sur ledit premier élément de contact (1a) étant plus éloignée desdites premierès extrémités dans le sens de l'allongement desdits éléments de contact (1a, 1b) que ladite deuxième partie de contact (1e) dudit deuxième élément de contact (1b), lesdites parties de contact (1c, 1e) étant positionnées pour pouvoir être déplacées de manière élastique dans une direction latérale par rapport à la fois à la direction d'allongement desdits éléments de contact et auxdites parties de contact par lequel moyen lesdites parties de contact (1c, 1e) peuvent être séparées de manière élastique dans ladite direction latérale pour former entre elles une ouverture (10) de réception de terminaison dans laquelle une terminaison peut être insérée sans application de force, et peuvent par la suite se déplacer ensemble pour serrer entre elles la terminaison, caractérisé en ce que lesdits premier et deuxième éléments de contact (1a, 1b) sont disposés en relation parallèle espacée dans un plan uniforme, et en ce que lesdites première et deuxième parties de contact (1c, 1e) sont disposées dans une relation opposée espacée dans ledit plan uniforme avec la surface inférieure de ladite première partie de contact (1c) et la surface supérieure de ladite deuxième partie de contact (1e) se faisant vis-à-vis et avec ladite première partie de contact dépassant par rapport à ladite deuxième partie de contact (1e) dans la direction de l'allongement de ladite première partie de contact (1c), la portion de ladite première partie de contact dépassant par rapport à ladite deuxième partie de contact étant une portion de réception de pression (1d), lesdites parties de contact (1c, 1e) pouvant être déplacées l'une par rapport à l'autre dans une direction latérale par rapport à la fois à ladite direction d'allongement desdits éléments de contact et auxdites parties de contact et transversalement audit plan uniforme sans faire obstacle l'une à l'autre, d'une manière prédominante par un mouvement de torsion de la première partie de contact (1c) autour dudit premier élément de contact (1a) pour former ladite ouverture (10) de réception de terminaison entre lesdites première et deuxième parties de contact (1c, 1e), quand une force est appliquée à ladite portion de réception de pression (1d).

2. Assemblage comprenant un corps de prise (2) comportant en lui au moins un enfoncement de réception de contact, un contact (1) selon la revendication 1 pour recevoir une terminaison et positionné dans ledit enfoncement, et un bloc mobile (3) sur ledit corps de prise (2) qui est mobile dans ladite direction latérale qui est normale à la direction de contact entre une terminaison et le contact (1), quand une terminaison est insérée lors de son utilisation dans le contact, et comportant sur lui une partie d'engagement avec le contact disposée pour engager ladite portion de réception de pression (1d); dans lequel ledit bloc est mobile dans ladite direction latérale pour appliquer une force à ladite portion de réception de pression (1d) pour déplacer ladite première partie de contact (1c) par rapport à ladite deuxième partie de contact (1e) pour permettre la réception d'une terminaison entre lesdites première et deuxième parties de contact (1c, 1e).

3. Assemblage selon la revendication 2 dans lequel ladite deuxième partie de contact (1e) est normalement disposée dans ledit corps de prise (2) de sorte qu'il est déplacé par rapport à la première partie de contact (1c) qui se trouve sur un côté de ladite deuxième partie de contact (1e) et qui est déplacée de l'autre côté de ladite deuxième partie de contact (1e) lors du mouvement dudit bloc (3) dans ladite direction latérale (fig. 10(c)).
